# EUROPEAN PATENT SPECIFICATION

(11) **EP 1 540 723 B1**
(45) Date of publication and mention of the grant of the patent: **15.12.2010**
(21) Application number: 03763892.1
(22) Date of filing: 16.07.2003
(51) Int. Cl.: H01L 21/762, H01L 21/20, H01L 33/00

(54) **A METHOD OF INCREASING THE AREA OF A USEFUL LAYER OF MATERIAL TRANSFERRED ONTO A SUPPORT**
VERFAHREN ZUR VERGRÖSSERUNG DER FLÄCHE EINER NÜTZLICHEN MATERIALSCHICHT, DIE AUF EINEN TRÄGER ÜBERTRAGEN WIRD
PROCEDE PERMETTANT D'ACCROITRE L'AIRE D'UNE COUCHE UTILE D'UN MATERIAU TRANSFERE SUR UN SUPPORT

(30) Priority: 17.07.2002 FR 0209017; 09.05.2003 US 468990 P
(43) Date of publication of application: 15.06.2005
(73) Proprietor: S.O.I.Tec Silicon on Insulator Technologies, 38190 Bernin (FR)
(72) Inventor: MALEVILLE, Christophe, F-38660 La Terrasse (FR)
(74) Representative: Bomer, Françoise Marie
(86) International application number: PCT/EP2003/007855
(87) International publication number: WO 2004/008527

(56) References cited:
- EP-A- 0 451 993
- EP-A- 1 059 663
- EP-A- 1 189 266
- US-A- 5 597 410

## Description

The present invention relates to a method of increasing the area of a useful layer of semiconductor material which is effectively transferred onto a support during the fabrication of substrates, in particular for electronics, optics, or optoelectronics.

Currently, all substrates fabricated using techniques combining bonding by molecular bonding (known as "wafer bonding") and transferring a useful layer onto a support have a zone known as a "peripheral ring".

Said ring is a zone located at the periphery of the support and for which transfer of the useful layer has not occurred, or when transfer has occurred, said ring is a zone in which the useful layer has been transferred partially, or has disappeared during subsequent treatment, due to its poor bonding to said support.

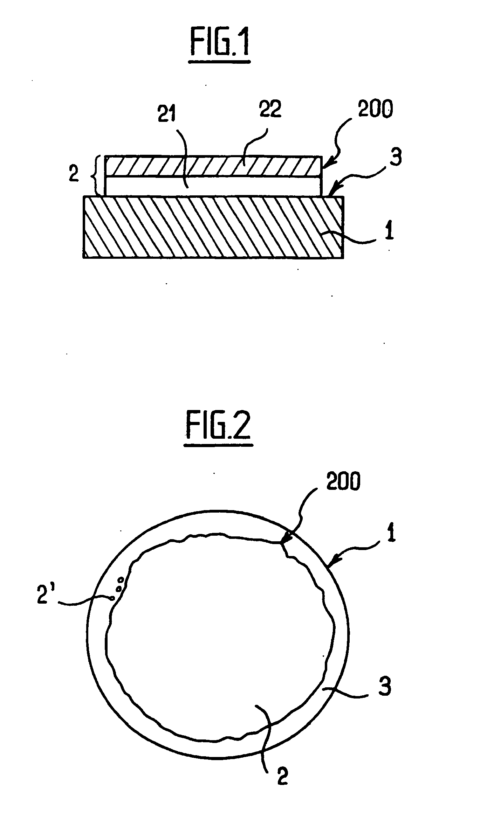

Accompanying Figures 1 and 2 are respective cross sectional and plan views of a substrate that is known to the skilled person under the acronym "SOI" meaning "silicon on insulator".

Figure 1 shows a support 1 of silicon onto which a composite layer 2 comprising a layer of silicon oxide 21 surmounted by a layer of silicon 22 has been transferred by molecular bonding.

The term "ring" 3 defines a substantially annular zone of support 1 onto which the composite layer 2 has either not been transferred or has been transferred poorly during transfer of the layer.

More precisely, in the plan view of Figure 2, it can be seen that this ring 3 is of varying width and/or shape, i.e. that the vertical side 200 of the composite layer 2 can be irregular (jagged) and/or that islands 2' of composite layer may exist that have been transferred onto the support 1, but that are spaced apart from the remainder of the central portion of said composite layer 2.

It should be noted that Figures 1 and 2 are diagrams that are not to scale both as regards the thickness of the different layers and of the support and as regards the width of the ring.

Said ring phenomenon occurs with other substrates, for example those known under the acronym "SICOI" meaning "silicon carbide on insulator" or under the acronym "SOQ" meaning "silicon on quartz". Other multi-layer substrates such as those comprising gallium arsenide on silicon (AsGa/Si) also exhibit said ring.

Independently of the diameter of support 1, which can vary, for example, from 2 inches (50 millimeters (mm)) for silicon carbide to 12 inches (300 mm) for certain silicon substrates, said ring 3 generally varies from 1 mm to 4 mm in width, plus-or-minus 0.5 mm. Further, said width can fluctuate, i.e., it can be smaller on one side of the substrate than on the other.

The appearance of said ring during layer transfer has a variety of origins, as discussed below. Particular mention can be made of the existence of chamfers on the substrates used, variations in bonding energy, and finally certain aggressive steps in substrate fabrication methods.

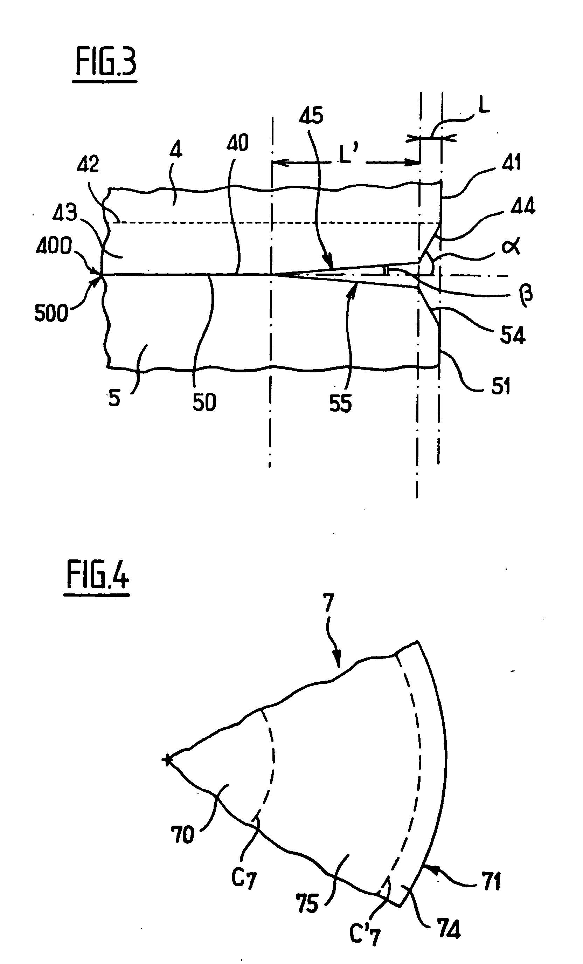

In order to explain the appearance of said ring, reference is made to the accompanying Figure 3 which is a diagrammatic cross section of a portion of the sides of two substrates bonded together by molecular bonding, namely a source substrate 4 from which the future useful layer is to be cut, and a support substrate 5 intended to receive said useful layer. This figure illustrates the prior art.

In the remainder of the description and drawings, the substrates are assumed to be circular in shape as this is the shape encountered most frequently. However, they can have other shapes.

The source substrate 4 has two opposite faces that are parallel; in Figure 3 reference numeral 400 designates a "front" one of said faces. Said front face 400 is intended for bonding onto said support 5. The source substrate 4 has a side 41.

Further, the substrate 4 has undergone treatment that forms a zone of weakness 42 that defines two portions, a rear portion and a useful layer 43 intended for subsequent transfer to the support 5.

Throughout the remainder of the description and claims, the expression "useful layer" designates a transferred layer of thickness that depends on whether it is obtained, for example, by a method of implanting atomic species or by abrasive polishing and/or chemical etching as is described below.

Currently, the substrates used both as the source substrate and as the support substrate are commercially available substrates satisfying standardized requirements (for example SEMI M1-0302 standards for a silicon substrate). Those standards are mainly concerned with ensuring said substrates can be accepted by the equipment of as wide a range of users as possible.

According to those standards, at the intersection between the side 41 and the front face 400, the substrate 4 has an annular primary chamfer 44 or primary drop making a large angle a (close to 45°) with the plane of said front face 400 and more precisely with the rigorously flat central zone 40, as will be explained below. Said primary chamfer 44 extends over a width L in the radial direction. Said width L varies from 100 micrometers (µm) to 500 µm depending on the different substrates. Said primary chamfer 44 is intended to limit the risk of mechanical rupture and notching of the source substrate 4.

In a similar manner to that just described for the source substrate 4, the support substrate 5 has a front face 500, a side 51 and a primary chamfer 54.

When substrates 4 and 5 are bonded to each other, bonding does not occur at chamfers 44 and 54 because of the magnitude of angle a. The width of the ring can thus be expected to correspond to the width L of said primary chamfers 44 and 54. It has been shown, however, that it is even wider in practice.

It has been observed that the front face 400 of substrate 4 actually has two zones, namely a first flat zone 40 located substantially at the center of said substrate 4 and hereinafter termed the "flat central zone" and a second zone 45 surrounding the first zone.

The second zone 45 is a secondary chamfer that is generally annular or a secondary drop forming an angle β with the plane of the flat central zone 40. Said secondary chamfer 45 extends between said flat zone 40 and the primary chamfer 44.

Throughout the remainder of the description and claims, the expression "flat" means a flatness that is suitable for bonding, and the expression "central zone" designates a zone located substantially at the center of the front face of the substrate but which can, however, be located slightly excentrically on said face.

It should be noted that Figure 3 and the following figures are only diagrammatic in nature and the magnitude of angle P has been considerably exaggerated in the figures for clarification purposes.

More precisely, the secondary chamfer 45 constitutes a drop that is less sharp than the primary chamfer 44 and which appears during the various substrate shaping steps (lapping, polishing, chemical etching), these steps producing an etching and material-removal effect that is greater on the substrate side. Said secondary chamfer 45 is not subject to standards. Its width L' taken in a radial direction varies from about 500 µm to 3000 µm on substrates that are commercially available on the market. Said secondary chamfer 45 is a poorly defined zone of dimensions that are not defined by the above-mentioned standards. Further, the value of angle β also fluctuates, and so secondary chamfer 45 is not flat as shown diagrammatically in Figure 3 but can be domed or irregular in places.

As a result, in reality (and in contrast to the diagrammatic representation of the figures), the side of the source substrate 4 is not formed by a plurality of beveled slopes but has a somewhat convex shape, i.e., without edges between the secondary chamfer 45 and the primary chamfer 44 or between the primary chamfer and the side 41. The purpose of the convex shape is to avoid any nicking of the substrate 4.

In a manner similar to that just described for the source substrate 4, the support substrate 5 has a flat central zone 50 and a substantially annular secondary chamfer 55, but has the same irregularities as the secondary chamfer 45.

Molecular bonding is a technique that cannot tolerate non-planar surfaces and the existence of said secondary chamfers 45, 55 results in poor bonding and layer transfer in that zone, resulting in the appearance of a peripheral ring.

In addition, a second reason for the appearance of said ring is that the bonding energy between two facing substrate faces fluctuates as a function of parameters such as roughness, flatness and the chemical nature of the surfaces in contact, the presence of particles, etc. Said parameters can also vary in a less controlled manner at the sides of the substrates, thereby also explaining the formation of the ring.

Finally, another possible cause for formation of the ring is the use of certain aggressive steps during the substrate fabrication methods.

Methods of fabricating substrates known under the acronym BESOI (bond and etchback silicon on insulator) bond a source substrate onto a support substrate, at least one of the faces of the source substrate being coated with a layer of oxide. The exposed surface of the source substrate then undergoes an abrasive polishing and/or chemical attack etching treatment followed by polishing until said source substrate becomes a useful layer.

In that type of method involving chemical attack (with the risk of partial delamination of the bonding interface), oxidation affecting the lateral and frontal portions of the source substrate, and mechanical abrasive polishing forces, both tend to enlarge the ring.

Similarly, in methods involving detachment of the layer by fracture along a zone of weakness, it has been observed that around the sides, detachment tends to occur at the bonding interface and not at the zone of weakness, resulting in the formation of an annular ring with a large surface area.

Referring again to Figure 3, in the particular case of the zone of weakness 42 being formed by hydrogen implantation, it has been shown that, during subsequent treatment to detach the useful layer 43 from the remainder of the source substrate 4, expansion of hydrogen bubbles exerts a substantially perpendicular force on the plane of the secondary chamfer 45. In that zone, said force is not compensated by sufficiently strong bonding, since the secondary chamfer 55 is spaced from the secondary chamfer 45 by an angle 2β and the bonding is thus ruptured. Thus, bubbles are formed at the surface of the secondary chamfer 45 instead of the layer 43 being transferred onto the support substrate 5. In other words, bonding occurs but its quality is bad.

A number of disadvantages are associated with the existence of said ring.

Firstly, it presents an unusable surface on which it is not possible to fabricate electronic components. Unfortunately, from an economic point of view, each extra square millimeter of area can make it possible to fabricate a larger number of components per substrate.

Furthermore, this ring is irregular as explained above, and its width can vary from one side to the other of the substrate, thus giving rise to problems of reproducibility in the various steps of an industrial process when such a substrate is used in a production facility.

The prior art includes methods of polishing the side of a substrate so as to make it possible to eliminate said ring, see for example document US 6 221 774.

A method of mechanically polishing sides is also known as used by the supplier SEZ. That method is used on solid silicon substrates after deposition operations which are known to run the risk of being associated with the effects of material being removed from the sides (known as "lift-off" or "peel-off"), i.e. leading to a high level of particulate contamination.

Nevertheless, those methods tend to increase the size of the zone having no transferred layer at the periphery, thereby restricting the useful area. In addition, finishing operations on the ring can lead to defects at the periphery of the transferred layer.

The document EP-1 059 663 describes a process for producing a semiconductor thin film comprising the steps of forming a semiconductor layer and a porous layer on a first substrate, removing said semiconductor layer at its peripheral region and separating the semiconductor layer from the first substrate by using a second substrate bonded to the surface of the semi-conductor layer.

This process aims to solve a splitting problem related to the fact that the transferred layer has been epitaxially grown on the porous layer.

This document has not as object to improve the bonding between two substates in order to increase the area of a useful layer transferred onto a support substrate.

To the contrary, the removing of the peripheral region of the semiconductor layer conducts to a restriction of the area of the useful layer transferred.

A method to make a SOI wafer for integrated circuits manufacturing is also described in the document US-5,597,410.

This method comprises the steps of :
- bonding the front surface of a holding wafer encapsulated by a first oxide layer onto the front surface of a bonding wafer encapsulated by a second oxide layer, the holding front surface being longer than the bonding front surface,
- etching the back and lateral surfaces of the second oxide layer and a portion of the first oxide layer,
- forming a polysilicon layer on all exposed surfaces of the assembly thus obtained, and
- removing the portion of the layer formed in previous step which covers the back surface of the bonding wafer, as well as a portion of said bonding wafer until it becomes planar with the portion of the polysilicon layer which remain above the front surface of the holding wafer.

The object of this method is to eliminate the sharp edge of the semiconductor film in SOI wafer fabricated with the prior art bonding wafer technique.

With such a method, the area of the transferred layer is even decreased by comparison to the prior art techniques.

An object of the present invention is thus to remedy the above-mentioned drawbacks, and in particular to reduce the area of said ring by increasing the quantity of material taken from the source substrate that is transferred onto a support during a layer transfer process.

To this end, the invention according to independent claim 1 provides a method of increasing the area of a useful layer of a material, in particular a semiconductor material, transferred onto a support substrate, during the fabrication of a composite substrate in particular for applications in the fields of electronics, optics, or optoelectronics.

By means of these characteristics of the invention, the useful layer is transferred over an area that is larger.

According to other advantageous and non-limiting characteristics of the invention, taken singly or in combination:
· the source substrate and the support substrate are of circular section, and the outside diameter of the source substrate is greater than the outside diameter of the support substrate;
· the dimensions of the outer outline of the flat central zone of the the source substrate are greater than the dimensions of the outer outline of the secondary chamfer of the support substrate, and during bonding, the substrates are applied one against the other in such a manner that the outer outline of the secondary chamfer of the support substrate is inscribed inside the outer outline of the flat central zone of the source substrate;
· the support substrate is bonded to the source substrate in such a manner that its flat central zone is centered relative to the flat central zone of said source substrate;
· prior to the step of bonding the source substrate and the support substrate against each other, the method comprises a step consisting in forming a zone of weakness inside said source substrating, said useful layer to be transferred extending between said zone of weakness and the front face of the source substrate, and after the bonding step, the method consists in detaching said useful layer from the remainder of the source substrate along said zone of weakness;
· said zone of weakness is formed by implanting atomic species or is formed by a porous layer;
· the useful layer is detached by at least one of the following techniques taken alone or in combination: applying stresses of mechanical or electrical origin; supplying thermal energy, and chemical etching;
· at least one of the faces of the front face of the source substrate and the front face of the support substrate is coated in a layer of an insulating material.

Other characteristics and advantages of the invention become apparent from the following description of several preferred implementations of the invention. This description is made with reference to the accompanying drawings in which:
· Figure 1 is a diagram showing a vertical diametrical section through an SOI type substrate;
· Figure 2 is a diagram showing a plan view of the substrate of Figure 1;
· Figure 3 is a diagram showing a fragmentary vertical section of a source substrate and a support substrate bonded together using a prior art technique;
· Figure 4 is a plan view of an angular section of a support used in the method of the invention;
· Figure 5 is a fragmentary diagram in vertical section showing a source substrate and a support substrate in a first implementation of the method of the invention, the two substrates being shown ready for being bonded together; and
· Figure 6 is a fragmentary diagram in vertical section showing a source substrate and a support substrate in a second implementation of the method, the two substrates being shown bonded together.

The aim of the invention is to improve the above-described method of fabricating a composite substrate, such a method including at least one step of molecular bonding one of the faces of a source substrate to a facing face of a support substrate, and a step of transferring a useful layer from said source substrate onto said support substrate.

Said composite substrates thus comprise at least one useful layer transferred onto a support.

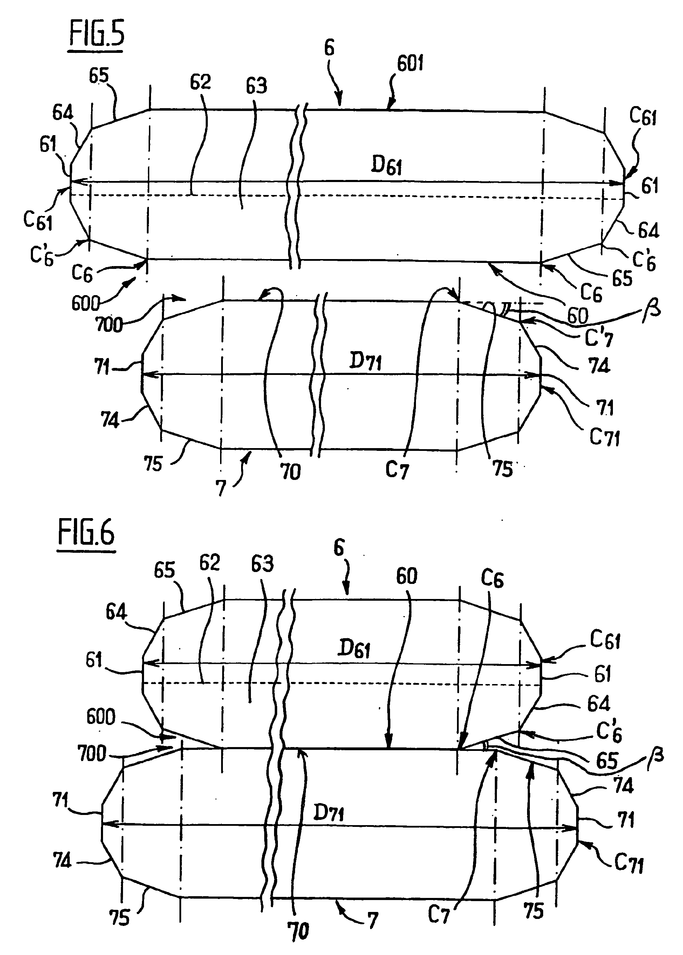

With reference now to Figure 5, there can be seen the implementation of the invention in which a source substrate 6 (from which a useful layer 63 is to be taken subsequently) is molecularly bonded to a support substrate 7.

In this implementation, the support substrate 7 is identical to the support substrate 5 described above and shown in Figure 3. It is therefore not described again in detail.

The support substrate 7 presents a side 71, a primary chamfer 74, and a front face 700 for receiving the front face 600 of the source substrate 6. This front face 700 covers both a flat central zone 70 and a secondary chamfer 75.

As shown in Figures 4 to 6, and as is usually the case, the source and support substrates 6 and 7 are circular. Similarly, their flat central zones are likewise circular, and the primary and secondary chamfers are described as being annular. Nevertheless, the substrates 6 and 7 and/or their respective central zones could be of other shapes, for example they could be oval, octagonal, or rectangular.

As can be seen more clearly in Figure 4, the secondary chamfer 75 is defined by an inner outline C₇ and by an outer outline C'₇. It should be observed that the inner outline C₇ of the secondary chamfer 75 constitutes the outer outline of the flat central zone 70, and similarly, the outer outline C'₇ of the secondary chamfer 75 constitutes the inner outline of the primary chamfer 74.

As shown in Figure 5, the source substrate 6 is a conventional substrate, i.e. it has a primary chamfer 64 and also a secondary chamfer 65, the secondary chamfer lying between an inner outline C₆ and an outer outline C'₆. The inner outline C₆ of the secondary chamfer 65 constitutes the outer outline of the flat central zone 60.

In accordance with the invention, the dimensions of the outer outline C₆₁ of the source substrate 6 taken at its side 61 are greater than the dimensions of the outer outline C₇₁ of the support substrate 7 taken at its side 71. When both substrates 6 and 7 are circular in section, the greatest diameter D₆₁ of the source substrate 6, i.e. the diameter as measured across the side 61 (referred to below as the outside diameter D₆₁) is greater than the outside diameter D₇₁ of the support substrate 7 (as measured across the side 71).

Given the usual fabrication tolerances on the substrates 6 and 7, it is preferable in practice for the source substrate 6 to have a diameter D₆₁ that is at least 0.3 mm greater than the diameter D₇₁ of the support substrate 7. Furthermore, when commercially-available substrates 6 and 7 are used of the kind that are made available in the form of a range of substrates of different increasing diameters, it is advantageous for the substrate 6 to be selected as having the diameter in the range that is the diameter immediately larger than that of the support substrate 7.

In addition, the dimensions of the outer outline C₆ of the flat central zone 60 of the source substrate 6 are greater than the dimensions of the inner outline C₇ of the secondary chamfer 75 of the support substrate 7, and during bonding, the source substrate 6 is applied against the support substrate 7 in such a manner that this inner outline C₇ is inscribed within the outer outline C₆.

Also preferably, the dimensions of the outline C₆ of the flat central zone 60 of the source substrate 6 are greater than the dimensions of the outer outline C'₇ of the secondary chamfer 75 of the support 7, and during bonding, the source substrate 6 is applied against the support substrate 7 in such a manner that the outer outline C'₇ is inscribed inside the outline C₆ of the flat central zone 60.

Thus, the secondary chamfer 75 of the support 7 is always situated facing the flat zone 60 of the substrate 6 and forms a small angle β relative thereto. Bonding between these two surfaces is improved and a larger fraction of the useful layer 63 is transferred onto the secondary chamfer 75. Consequently, the area of the useful layer 63 that is actually transferred increases, and conversely the area of the ring decreases. This solution is also simple to implement since substrates of different diameters are already available on the market.

Finally, and advantageously, the source substrate 6 is bonded to the support substrate 7 in such a manner that the flat central zone 70 of the support 7 is centered relative to the central zone 60 of the source substrate 6. Thus, the useful layer 63 as transferred is also centered or substantially centered relative to the support 7.

A second example not being part of the invention is described below with reference to Figure 6.

This implementation is similar to that described with reference to Figure 5, except that in this case it is the support substrate 7 which presents a diameter that is larger than that of the source substrate 6.

In this case, the dimensions of the outer outline C₇₁ of the support substrate 7 are greater than the dimensions of the outer outline C₆₁ of the source substrate 6. When both substrates are circular in section, the diameter D₇ of the support 7 is greater than the diameter D₆ of the source substrate 6.

The remarks made above relative to the first implementation concerning the difference in diameter between the substrates being at least 0.3 mm and concerning the use of commercially-available substrates applies likewise in this second example.

In addition, the dimensions of the outer outline C₇ of the flat zone 70 of the support 7 are greater than the dimensions of the inner outline C₆ of the secondary chamfer 65 of the source substrate 6, and during bonding, the source substrate 6 is applied against the support substrate 7 in such a manner that this inner outline C₆ is inscribed within said outline C₇.

Also preferably, the dimensions of the outline C₇ are greater than the dimensions of the outer outline C'₆ of the secondary chamfer 65 of the source substrate 6, and during bonding the source substrate 6 is applied against the support substrate 7 in such a manner that this outer outline C'₆ is inscribed inside said outline C₇.

Advantageously, the substrates 6 and 7 are also centered relative to each other.

Thus, as can be seen on figure 6, the secondary chamfer 65 of the support 6 is always situated facing the flat central zone 70 of the substrate 7 and forms a small angle β relative thereto, thus improving the bonding of the two substrates. Consequently, the area of the useful layer 63 that is transferred increases.

The implementation of Figure 5 in which the source substrate 6 is of dimensions greater than those of the support substrate 7 is advantageous for reasons associated with implementing the method on an industrial scale.

The useful layer 63 can be removed from the source substrate 6 in a variety of manners which are now described.

In a first variation, prior to the step of molecular bonding substrates 6 and 7 to each other, a zone of weakness 62 is formed within the source substrate 6 to define and delimit the useful layer 63 subsequently transferred to the support 7. After bonding, said useful layer 63 is detached from the remainder of the source substrate 6 along this zone of weakness 62.

It should be observed that Figures 5 and 6 are merely diagrammatic and, for clarification purposes, the useful layer 63 is shown therein as being much thicker than it is in reality.

Techniques for forming said zone of weakness 62 are known to the skilled person and are not all described in detail.

Advantageously, this zone of weakness 62 is formed by implanting atomic species from the front face 600.

The term "implanting atomic species" means any bombardment of atomic, molecular or ionic species, which can introduce said species into a material with a maximum concentration of said species located at a predetermined depth from the bombarded surface 600. The molecular or ionic atomic species are introduced into the material with an energy that is also distributed about a maximum.

Atomic species can be implanted into said source substrate 6 using an ion beam implanter or a plasma immersion implanter, for example.

Preferably, implantation is carried out by ionic bombardment. Preferably, the implanted ionic species is hydrogen. Other ionic species can advantageously be used alone or in combination with hydrogen, such as rare gases (for example helium).

Implantation creates the zone of weakness 62 within the bulk of the source substrate 6 and at a mean ion penetration depth, the zone being substantially parallel to the plane of the front face 600. The useful layer 63 extends from the front face 600 to this zone of weakness 62.

Reference should be made, for example to the literature concerning the method known by its registered trade mark "Smart Cut".

The zone of weakness 62 can also be constituted by a porous layer obtained, for example, using the method known by its registered trade mark "ELTRAN" from Canon, described in European patent EP-A-0 849 788.

After the step of molecular bonding the faces 600 and 700, the useful layer 63 is detached from the remainder of the source substrate 6.

Detachment of the useful layer 63 is performed subsequently by at least one of the following techniques alone or in combination: applying constraints of mechanical origin (inserting a blade or a jet of fluid under pressure into the zone of weakness 62) or of electrical origin, supplying heat energy, and chemical etching. These detachment techniques are known to the skilled person and they are not described in greater detail. This provides a composite substrate having a useful layer 63 transferred onto a support 7.

As mentioned above, the useful layer 63 is detached horizontally, along the zone of weakness 62 and also by means of "vertical self-limitation" vertically in register with the zone where bonding to the support is of sufficient strength.

Finally, in a variation of the implementation not shown in figures, it is also possible to produce the useful layer 63 by the technique known as "bond and etchback" in which, after bonding the front face 600 of the source substrate 6 onto the front face 700 of the support substrate 7, the rear face 601 of said source substrate 6 undergoes treatment by lapping and/or etching by chemical attack, and then polishing, until only the thickness corresponding to said useful layer 63 remains on the support 7. In the particular case of SOI (silicon on insulator) substrates, it is possible to obtain the useful layer 63 by the BESOI method mentioned in the introduction of this application.

Finally, examples of materials to which said method can be applied are given.

The support substrate 7 is formed from a material that is optionally a semiconductor and that is selected, for example, from: silicon; a transparent substrate (such as quartz or glass, for example); silicon carbide; gallium arsenide; indium phosphide; or germanium.

Preferably, the source substrate 6 is formed from a semiconductor material selected, for example, from: silicon; germanium; silicon carbide; silicon and germanium alloys or "compounds" (known as Si-Ge compounds); or alloys or compounds known as III/V compounds, i.e., compounds one element of which is from column IIIa of the periodic table and the other is from column Va, such as gallium nitride; gallium arsenide; or indium phosphide.

Finally, it should be noted that it is possible to cover the front face 700 of the support 7 with an insulating layer of the oxide type (for example SiO₂) or of the nitride type (for example Si₃N₄), this insulating layer then being interposed between the useful layer 63 and said support 7, after detaching said layer 63.

It is possible to cover the front face 600 of the source substrate 6 with an insulating material of the type mentioned above, the transferred useful layer 63 then comprising two layers. It is even possible to deposit a plurality of layers onto the source substrate 6 and the term "useful layer" then designates a stack of layers.

## Claims

1. A method of increasing the area of a useful layer (63) of a material, in particular a semiconductor material, issued from a source substrate (6), transferred onto a support substrate (7), during the fabrication of a composite substrate in particular for applications in the fields of optics, electronics, or optoelectronics, one face of said source substrate (6) and one face of said support substrate (7), termed "front faces" (600, 700) having a flat central zone (60, 70) with a respective outline (C₆, C₇), and being surrounded by a primary chamfer (64, 74), the dimensions of the outer outline (C₆₁) of said source substrate (6) being greater than the dimensions of the outer outline (C₇₁) of the support substrate (7), this method comprising the steps consisting in molecular bonding both front faces (600, 700) and in transferring said useful layer (63) onto said support substrate (7), said useful layer (63) extending inside said source substrate (6) from its front face (600), the method being **characterized in that** both front faces (600, 700) of said source substrate (6) and support substrate (7) present a secondary chamfer (65, 75) extending between said flat central zone (60, 70) and said primary chamfer (64, 74), **in that** the outer outline (C₆) of the flat central zone (60) of said source substrate (6) presents dimensions greater than the dimensions of the inner outline (C₇) of the secondary chamfer (75) of said support substrate (7), and **in that** during bonding, the substrates (6, 7) are applied one against the other in such a manner that the inner outline (C₇) of the secondary chamfer (75) of the support substrate (7) is inscribed within the outline (C₆) of the flat central zone (60) of the source substrate (6), in order to improve bonding between the secondary chamfer (75) of the support substrate (7) and the flat central zone (60) of the source substrate (6).

2. A method according to claim 1, **characterized in that** the source substrate (6) and the support substrate (7) are of circular section, and **in that** the outside diameter (D₆₁) of the source substrate (6) is greater than the outside diameter (D₇₁) of the support substrate (7).

3. A method according to claim 1 or claim 2, **characterized in that** the dimensions of the outer outline (C₆) of the flat central zone (60) of the source substrate (6) are greater than the dimensions of the outer outline (C'₇) of the secondary chamfer (75) of the support substrate (7), and **in that** during bonding, the substrates are applied one against the other in such a manner that the outer outline (C'₇) of the secondary chamfer (75) of the support substrate (7) is inscribed inside the outer outline (C₆) of the flat central zone (60) of the source substrate (6).

4. A method according to any preceding claim, **characterized in that** the support substrate (7) is bonded to the source substrate (6) in such a manner that its flat central zone (70) is centered relative to the flat central zone (60) of said source substrate (6).

5. A method according to any preceding claim, **characterized in that** prior to the step of bonding the source substrate (6) and the support substrate (7) against each other, the method comprises a step consisting in forming a zone of weakness (62) inside said source substrate (6), said useful layer (63) to be transferred extending between said zone of weakness (62) and the front face (600) of the source substrate (6), and after the bonding step, the method consists in detaching said useful layer (63) from the remainder of the source substrate (6) along said zone of weakness (62).

6. A method according to claim 5, **characterized in that** said zone of weakness (62) is formed by atomic species implantation.

7. A method according to claim 5, **characterized in that** said zone of weakness (62) is formed by a porous layer.

8. A method according to any one of claims 5 to 7, **characterized in that** the useful layer (63) is detached by at least one of the following techniques taken alone or in combination: applying stresses of mechanical or electrical origin; supplying thermal energy; and chemical etching.

9. A method according to any preceding claim, **characterized in that** at least one of the faces selected from the front face (600) of the source substrate (6) and the front face (700) of the support substrate (7) is coated in a layer of an insulating material.

## Patentansprüche

1. Verfahren zum Vergrößern des Bereichs einer Nutzschicht (63) eines Materials, insbesondere eines Halbleitermaterials, das von einem Quellensubstrat (6) stammt und auf ein Trägersubstrat (7) übertragen wird während der Herstellung eines zusammengesetzten Substrats insbesondere für Anwendungen im Optik-, Elektronik oder Optoelektronikbereich, wobei eine Seite des Quellensubstrats (6) und eine Seite des Trägersubstrats (7), bezeichnet als "Vorderseiten" (600,700), eine flache mittige Zone (60, 70) mit einer jeweiligen Kontur (C₆, C₇) aufweisen und von einer primären Abschrägung (64, 74) eingefasst sind, wobei die Dimensionen der Außenkontur (C₆₁) des Quellensubstrats (6) größer als die Dimensionen der Außenkontur (C₇₁) des Trägersubstrats (7) sind, wobei das Verfahren Schritte umfasst, die darin bestehen, die beiden Vorderseiten (600, 700) molekular zu verbinden und die Nutzschicht (63) auf das Trägersubstrat (7) zu übertragen, wobei die Nutzschicht (63) sich von der Vorderseite (600) ins Innere des Quellensubstrats (6) erstreckt, wobei das Verfahren **dadurch gekennzeichnet ist, dass** beide Vorderseiten (600, 700) des Quellensubstrats (6) und des Trägersubstrats (7) eine sekundäre Abschrägung (65, 75) aufweisen, die sich zwischen der flachen mittigen Zone (60, 70) und der primären Abschrägung (64, 74) erstreckt, dass die Außenkontur (C₆) der flachen mittigen Zone (60) des Quellensubstrats (6) größere Dimensionen aufweist als die Dimensionen der Innenkontur (C₇) der sekundären Abschrägung (75) des Trägersubstrats (7), und dass während des Verbindens die Substrate (6, 7) derart aneinander angelegt werden, dass die Innenkontur (C₇) der sekundären Abschrägung (75) des Trägersubstrats (7) innerhalb der Kontur (C₆) der flachen mittigen Zone (60) des Quellensubstrats (6) liegt, um eine Verbindung zwischen der sekundären Abschrägung (75) des Trägersubstrats (7) und der flachen mittigen Zone (60) des Quellensubstrats (6) zu verbessern.

2. Verfahren nach Anspruch 1, **dadurch gekennzeichnet, dass** das Quellensubstrat (6) und das Trägersubstrat (7) von einem kreisförmigen Querschnitt sind, und dass der Außendurchmesser (D₆₁) des Quellensubstrats (6) größer als der Außendurchmesser (D₇₁) des Trägersubstrats (7) ist.

3. Verfahren nach Anspruch 1 oder 2, **dadurch gekennzeichnet, dass** die Dimensionen der Außenkontur (C₆) der flachen mittigen Zone (60) des Quellensubstrats (6) größer als die Dimensionen der Außenkontur (C'₇) der sekundären Abschrägung (75) des Trägersubstrats (7) sind, und **dadurch**, dass während des Verbindens die Substrate derart aneinander angelegt werden, dass die Außenkontur (C'₇) der sekundären Abschrägung (75) des Trägersubstrats (7) innerhalb der Außenkontur (C₆) der flachen mittigen Zone (60) des Quellensubstrats (6) liegt.

4. Verfahren nach einem der vorangehenden Ansprüche, **dadurch gekennzeichnet, dass** das Trägersubstrat (7) mit dem Quellensubstrat (6) derart verbunden wird, dass seine flache mittige Zone (70) relativ zu der flachen mittigen Zone (60) des Quellensubstrats (6) zentriert ist.

5. Verfahren nach einem der vorangehenden Ansprüche, **dadurch gekennzeichnet, dass** das Verfahren vor dem Schritt des Aneinanderbindens des Quellensubstrats (6) und des Trägersubstrats (7) einen Schritt umfasst, der darin besteht, eine Schwachheitszone (62) im Quellensubstrat (6) auszubilden, wobei die zu übertragende Nutzschicht (63) sich zwischen der Schwachheitszone (62) und der Vorderseite (600) des Quellensubstrats (6) erstreckt, und dass das Verfahren nach dem Verbindungsschritt darin besteht, die Nutzschicht (63) vom Rest des Quellensubstrats (6) entlang der Schwachheitszone (62) abzulösen.

6. Verfahren nach Anspruch 5, **dadurch gekennzeichnet, dass** die Schwachheitszone (62) durch Implantation von Atomarten gebildet wird.

7. Verfahren nach Anspruch 5, **dadurch gekennzeichnet, dass** die Schwachheitszone (62) durch eine poröse Schicht gebildet wird.

8. Verfahren nach einem der Ansprüche 5 bis 7, **dadurch gekennzeichnet, dass** die Nutzschicht (63) durch wenigstens eine der folgenden Techniken allein oder in Kombination abgelöst wird: Ausüben von Beanspruchung mechanischen oder elektrischen Ursprungs; Bereitstellen von Wärmeenergie; und chemisches Ätzen.

9. Verfahren nach einem der vorangehenden Ansprüche, **dadurch gekennzeichnet, dass** wenigstens eine der Seiten ausgewählt aus der Vorderseite (600) des Quellensubstrats (6) und der Vorderseite (700) des Trägersubstrats (7) mit einer Schicht eines isolierenden Materials beschichtet ist.

## Revendications

1. Procédé pour l'augmentation de l'aire d'une couche utile (63) d'un matériau, en particulier un matériau semi-conducteur, provenant d'un substrat source (6), transféré sur un substrat support (7), pendant la fabrication d'un substrat composite en particulier pour des applications dans les domaines de l'optique, de l'électronique ou de l'optoélectronique, une face dudit substrat source (6) et une face dudit substrat support (7), appelées « faces avant » (600, 700) ayant une zone centrale plate (60, 70) avec un contour (C₆, C₇) et étant entourées par un chanfrein primaire (64, 74), les dimensions du contour externe (C₆₁) dudit substrat source (6) étant supérieures aux dimensions du contour externe (C₇₁) du substrat support (7), ce procédé comprenant les étapes consistant à coller de manière moléculaire les deux faces avant (600, 700) et à transférer ladite couche utile (63) sur ledit substrat support (7), ladite couche utile (63) s'étendant à l'intérieur dudit substrat source (6) à partir de sa face avant (600), le procédé étant **caractérisé en ce que** les deux faces avant (600, 700) dudit substrat source (6) et du substrat support (7) présentent un chanfrein secondaire (65, 75) s'étendant entre ladite zone centrale plate (60, 70) et ledit chanfrein primaire (64, 74), **en ce que** le contour externe (C₆) de la zone centrale plate (60) dudit substrat source (6) présente des dimensions supérieures aux dimensions du contour interne (C₇) du chanfrein secondaire (75) dudit substrat support (7), et **en ce que** pendant l'étape de collage, les substrats (6, 7) sont appliqués l'un sur l'autre de sorte que le contour interne (C₇) du chanfrein secondaire (75) du substrat support (7) est inscrit dans le contour (C₆) de la zone centrale plate (60) du substrat source (6), afin d'améliorer le collage entre le chanfrein secondaire (75) du substrat support (7) et la zone centrale plate (60) du substrat source (6).

2. Procédé selon la revendication 1, **caractérisé en ce que** le substrat source (6) et le substrat support (7) ont une section circulaire, et **en ce que** le diamètre externe (D₆₁) du substrat source (6) est supérieur au diamètre externe (D₇₁) du substrat support (7).

3. Procédé selon la revendication 1 ou la revendication 2, **caractérisé en ce que** les dimensions du contour externe (C₆) de la zone centrale plate (60) du substrat source (6) sont supérieures aux dimensions du contour externe (C'₇) du chanfrein secondaire (75) du substrat support (7), et **en ce que**, pendant le collage, les substrats sont appliqués l'un contre l'autre de sorte que le contour externe (C'₇) du chanfrein secondaire (75) du substrat support (7) est inscrit dans le contour externe (C₆) de la zone centrale plate (60) du substrat source (6).

4. Procédé selon l'une quelconque des revendications précédentes, **caractérisé en ce que** le substrat support (7) est collé sur le substrat source (6) de sorte que sa zone centrale plate (70) est centrée par rapport à la zone centrale plate (60) dudit substrat source (6).

5. Procédé selon l'une quelconque des revendications précédentes, **caractérisé en ce qu'**avant l'étape consistant à coller le substrat source (6) et le substrat support (7) l'un contre l'autre, le procédé comprend une étape consistant à former une zone de fragilisation (62) à l'intérieur dudit substrat source (6), ladite couche utile (63) destinée à être transférée, s'étendant entre ladite zone de fragilisation (62) et la face avant (600) du substrat source (6), et après l'étape de collage, le procédé comprend l'étape consistant à détacher ladite couche utile (63) du reste du substrat source (6) le long de ladite zone de fragilisation (62).

6. Procédé selon la revendication 5, **caractérisé en ce que** ladite zone de fragilisation (62) est formée par l'implantation d'espèces atomiques.

7. Procédé selon la revendication 5, **caractérisé en ce que** ladite zone de fragilisation (62) est formée par une couche poreuse.

8. Procédé selon l'une quelconque des revendications 5 à 7, **caractérisé en ce que** la couche utile (63) est détachée par au moins l'une des techniques suivantes prises seules ou en combinaison : l'application de contraintes d'origine mécanique ou électrique ; l'alimentation d'énergie thermique ; et la gravure chimique.

9. Procédé selon l'une quelconque des revendications précédentes, **caractérisé en ce qu'**au moins l'une des faces sélectionnées parmi la face avant (600) du substrat source (6) et la face avant (700 du substrat support (7) est recouverte d'une couche d'un matériau isolant.
